(19) **Europäisches Patentamt**

**European Patent Office**

**Office européen des brevets**

(11) **EP 0 537 730 B1**

(12) **EUROPEAN PATENT SPECIFICATION**

(45) Date of publication and mention
of the grant of the patent:
**30.01.2002 Bulletin 2002/05**

(51) Int Cl.⁷: **H01L 31/0224**, H01L 31/0392

(21) Application number: **92117612.9**

(22) Date of filing: **15.10.1992**

(54) **Solar cell**

Sonnenzelle

Cellule solaire

(84) Designated Contracting States:
**CH DE FR GB IT LI**

(30) Priority: **18.10.1991 JP 27103391**

(43) Date of publication of application:
**21.04.1993 Bulletin 1993/16**

(60) Divisional application:
**99107885.8**

(73) Proprietor: **CANON KABUSHIKI KAISHA
Tokyo (JP)**

(72) Inventor: **Takehara, Nobuyoshi,
c/o CANON KABUSHIKI KAISHA
Ohta-ku, Tokyo 146 (JP)**

(74) Representative:
**Leson, Thomas Johannes Alois, Dipl.-Ing. et al
Patentanwälte Tiedtke-Bühling-Kinne & Partner,
Bavariaring 4
80336 München (DE)**

(56) References cited:
**DE-A- 3 804 831          US-A- 4 084 985**

- **PATENT ABSTRACTS OF JAPAN vol. 12, no. 461
(E-689) 5 December 1988 &JP-A-63 185 071
( MATSUSHITA ELECTRIC IND CO LTD ) 30 July
1988**
- **PATENT ABSTRACTS OF JAPAN vol. 13, no. 264
(E-774) 19 June 1989 & JP-A-1 057 762
( KYOCERA CORP ) 6 March 1989**
- **PATENT ABSTRACTS OF JAPAN vol. 9, no. 019
(E-292) 25 January 1985 & JP-A-59 167 056
( KOGYO GIJUTSUIN ) 20 September 1984**
- **PATENT ABSTRACTS OF JAPAN vol. 9, no. 19
(E-292) 25 January 1985 & JP-A-59 167 057
( KOGYO GIJUTSUIN ) 20 September 1984**
- **PATENT ABSTRACTS OF JAPAN vol. 9, no. 19
(E-292)25 January 1985 & JP-A-59 168 669
( HITACHI SEISAKUSHO) 22 September 1984**

EP 0 537 730 B1

**Description**

BACKGROUND OF THE INVENTION

Field of the Invention

The present invention relates to a solar cell for use as a power supply to a variety of electronic equipments or a power source for power plant. More particularly, the invention relates to a solar cell having its electrode structure improved and excellent in the environment proof. Also, it relates to a solar cell which has a cheap, flexible and durable grid.

Related Background Art

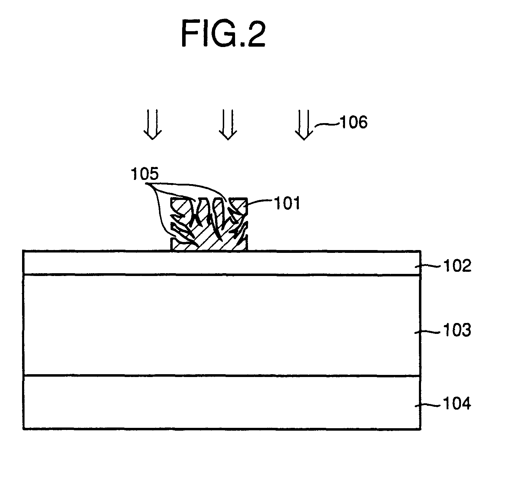

In recent years, people take growing interests in the environment and the energy on account of warmer environments of the earth or the radioactive pollution due to an atomic power plant accident. In these situations, the solar cell has been expected from all over the world as a reproducible, inexhaustible clean energy. At present, three types of solar cell have been well known; single crystal silicon type, polycrystalline silicon type, and amorphous silicon type. An amorphous silicon type solar cell has excellent characteristics such as the thin film operation ability by virtue of its easy realization of large area or a great light absorption coefficient, unlike the crystal type solar cell, though it is interior in the conversion efficiency to the crystal type solar cell, and thus the amorphous silicon type solar cell is expected as one of the promising solar cells. Since the cost is estimated to be significantly reduced as compared with the crystal type if the production reaches several hundreds MW, many studies have been made effortfully over the world. An example of the conventional amorphous silicon type solar cell is shown in Fig. 2. A photoelectric conversion semiconductor layer 103 made of amorphous silicon is formed on an electric conductive substratum 104, and a transparent electric conductive layer 102 also useful as an anti-reflection layer is formed thereon. On the transparent electric conductive layer is formed a grid electrode for collector 101. If light 106 is incident on the photoelectric conversion layer 103 from the grid electrode 101, as shown in Fig. 2, light energy is converted into electric current within the conversion layer, and taken out through the transparent electric conductive layer 102 from the grid electrode for collector 101 and the electric conductive substratum 104 as the output. The photoelectric conversion layer 103 contains at least one or more pin or pn junctions, with the p side acting as the anode and the n side as the cathode.

DE 38 04 831 C1 discloses an electrically conductive varnish for contacting of solar cells which is applied by a screen printing method to obtain a solar cell having an electrode comprising this varnish. The conductive varnish contains 10 to 45% by weight of an organic solvent. This varnish is said to have good screen printing properties and long-term stability as well as a low transition resistance.

When the solar cell is used outdoors, the particularly excellent characteristics in the environment proof are required. However, studies by the present inventor have revealed that in a conventional grid electrode, a short-circuit may take place between the electrodes of the solar cell due to water content permeating a gap in the electrode, which is one of the causes of decreasing the conversion efficiency. For example, a constitution of conventional grid electrode is disclosed in Japanese Laid-Open Patent Application No. 59-167056, Japanese Laid-Open Patent Application No. 59-167057, and Japanese Laid-Open Patent Application No. 59-168669. Specifically, according to the art as described in Japanese Laid-Open Patent Application No. 59-167056, the grid electrode is constituted of a conductive paste composed of silver 80wt% and phenolic resin 20wt%, but it is poor in durability and the cavity volume (as shown at 105 in Fig. 2) may increase with the time. With such a conventional art, it is difficult to produce a solar cell having no degradation of the conversion efficiency in the environment proof. This respect will be described later in detail.

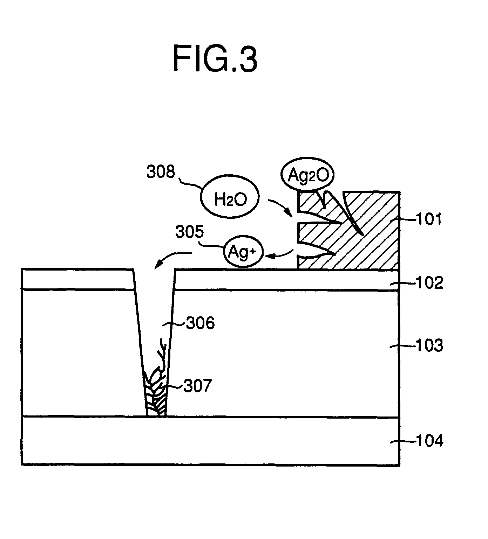

In general, the solar cell having an output of several W or greater is used outdoors. Therefore, the so-called environment proof characteristics for the temperature and the humidity are required. Particularly in the solar cell having a grid electrode for collector, conductive base substance such as silver or the like (as shown with $Ag_2O$ in Fig. 3) contained in the grid electrode may solve out by the permeation of water (as shown with $Ag_2O$ in Fig. 3) and by the photoelectromotive force of the substance so as to diffuse through defective portions such as pinholes or exfoliations, causing a short-circuit between the positive and negative electrodes of the solar cell, and thereby greatly decreasing the conversion efficiency. For example, when the conductive base substance is silver, the reaction proceeds between the anode and the cathode according to the following formula, thereby giving rise to a short-circuit.

$$\text{Anode} \qquad Ag_2O + H_2O \rightarrow 2Ag^+ + 2OH^- \qquad\qquad\qquad (A)$$

$$\text{Cathode} \quad Ag^+ + e^- \rightarrow Ag \text{ (dendrite crystal deposition)} \qquad (B)$$

This behavior is shown in Fig. 3. A silver ion 305 arising from a positive-side collector electrode 101 enters a pinhole 306 existing in the photoelectric conversion semiconductor layer 103 owing to an electric field produced by the absorption of light, sticking to the conductive substratum 104 to form a dendrite crystal 307. If the dendrite crystal grows, the collector electrode 101 of solar cell is electrically shorted to the conductive substratum 104, so that the output of solar cell can not be sufficiently taken out. That is, the degradation of the conversion efficiency may occur.

## SUMMARY OF THE INVENTION

In the light of the aforementioned drawbacks, an object of the present invention is to provide a solar cell which is high in the environment proof and unlikely to degrade in the conversion efficiency.

The above object of the present invention can be accomplished by a solar cell having a photoelectric conversion semiconductor layer and an electrode made from a solventless conductive material containing a conductive base substance and a resin electrically connected to the photoelectric conversion semiconductor layer, wherein the volume of cavities having a diameter of 0.1 μm or greater among cavities existing in the electrode is 0.04 cm$^3$/g or less.

According to the present invention, water content is prevented from entering cavities existing in the electrode to erode and break the electrode, so that the excellent photoelectric conversion efficiency of solar cell can be maintained for a long term.

The photoelectric conversion semiconductor layer for use in the present invention may be a single crystal semiconductor layer, a polycrystal semiconductor layer or amorphous semiconductor layer as a non-single crystal semiconductor layer, or a crystallite semiconductor layer. Specific examples include silicon, germanium, carbon, silicon germanium, silicon carbide, CdSe, CdSeTe, CdTeAs, ZnSe, GaAs or the like in the above crystal structure. In order to generate the photoelectromotive force, pn junction, pin junction, Schottky junction, hetero junction or the like is formed, using such a photoelectric conversion semiconductor layer.

The electrode for use in the present invention is disposed directly or via another layer interposed therebetween on at least one face of the above photoelectric conversion semiconductor layer.

The electrode for use in the present invention will be described below, but to facilitate the understanding of the contents of the art, an instance of the solar cell according to the present invention will be described in which amorphous silicon deposited on the conductive substratum is used as the photoelectric conversion semiconductor layer.

An amorphous silicon layer having at least one pin junction is formed on a flat conductive substratum by plasma CVD using a silane gas. The conductive substratum may be a plate or sheet substratum of stainless, aluminum, copper, or titanium, or a carbon sheet or the like. Also, the substratum may be a resin substratum having metal or the like deposited thereon.

On such substratum, a transparent conductive layer composed of indium oxide, tin oxide or the like is formed by vapor deposition, spraying, or the like.

Further, a solventless conductive paste containing a conductive base substance and a resin is applied on the transparent conductive layer by screen printing or relief printing, and cured at a temperature of 100 to 200°C, whereby a grid electrode for collector is attached. In order to constitute the solar cell of the present invention, it is significantly important to select or adjust the conductive paste on the following viewpoints of the present inventor found independently as a result of energetic studies.

(1) To make the amount of solvent contained in the conductive paste as small as possible.
(2) To use a resin containing the smallest amount of volatile component as possible arising in crosslinking of the resin.

The solar cell of the present invention can be constituted by using a solventless conductive paste meeting the above viewpoints found by the present inventor. As a solvent will increase the cavity volume in the grid, the conductive material used in the inventive solar cell is solventless, and is preferably a solventless type paste.

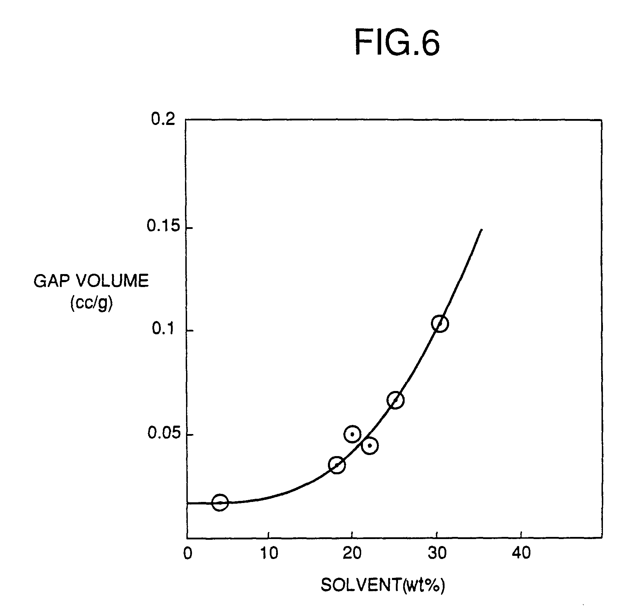

The relation between the solvent weight percent and the cavity volume is shown in Fig. 6. From Fig. 6, it can be found that the cavity volume decreases with decreasing solvent weight percent.

Examples of the conductive base substance include silver, silver-palladium alloy, a mixture of silver and carbon, copper, nickel, aluminum, gold and a mixture thereof. To obtain a conductivity necessary for passing the electric current as the grid electrode, the conductive base substance is preferably contained at 70 wt%, and more preferably at 75 wt% or greater. Preferable examples of the resin include urethan type, epoxy type, polyimide type, polyester type, phenol type, vinyl type, acrylic type or the like. Particularly, the epoxy type is most preferable from the view-point of the waterproof and the economy. The curing temperature of the conductive paste is preferably as high as possible in order to raise the density of crosslinking for the resin, but since too high temperature will burn the resin to thereby increase the cavity volume, it should be appropriately selected and set within the range of accomplishing the objects of the present invention. For example, in the urethan type or epoxy type resin, it is desirably 200°C or less. Also, to secure a certain density of crosslinking, it is desirable to cure the resin at least at 100°C or greater for more than ten minutes. Since impurities such as chlorine, sodium or the like contained in the conductive paste will facilitate the creation of silver ions as the catalyst in such an electromigration reaction, it is preferable to contain an amount of impurities as small as possible.

Next, the electrode for use in the present invention and gaps existing therein will be described in detail.

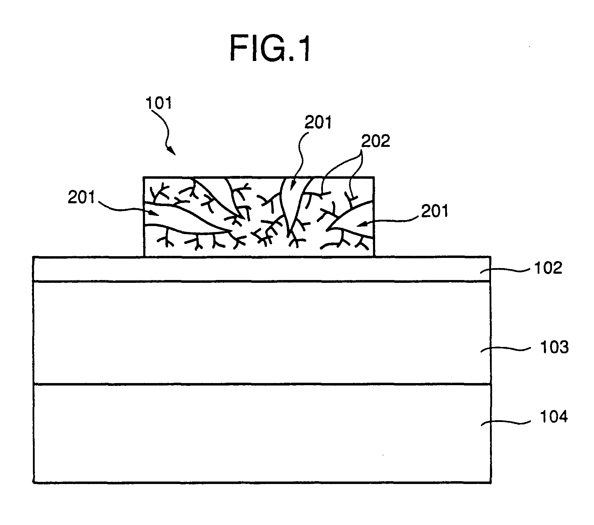

Fig. 1 is a typical view for explaining the solar cell according to an embodiment of the present invention.

A collector electrode 101 is provided on a photoelectric conversion semiconductor layer 103 and a transparent conductive layer 102 sequentially formed on a substratum 104.

Herein, 201 shows a relative large cavity having a diameter of, for example 0.1 µm or greater, and 202 shows a relatively small cavity having a diameter of, for example, less than 0.1 µm.

According to the views of the present inventors, since water content flows through the large cavity 201 into the cavity 202 where the micro-reaction may occur, it is possible to substantially prevent water content entering therein if the volume of the cavity 201 is as small as 0.04 cm$^3$/g or less.

The shape of cavity is such that the shape of opening on the electrode surface and the shape of cavity in cross section within the electrode may be any one ranging from a polygon to a star such as a circle, an ellipse, a triangle and a quadrangle. And each cavity may or may not communicate to one another.

The cavity diameter and the cavity volume as defined in the present invention can be obtained in the following way.

Based on the principle of capillary phenomenon, the liquid producing no wetting, which indicates a contact angle from 90° to 180° to most substances, will not enter the pore unless force-fully pressed, and enter correctly the pore in accordance with the applied pressure and the size (diameter) of pore, so that the volume of mercury permeating the pore can be measured by the diameter of pore and the work used to force mercury into the pore as the function of the applied pressure. With this mercury porosimetry, the diameter and the volume of cavity in the grid electrode can be obtained.

According to the present invention, if the cavity volume having a cavity diameter of 0.1 µm or greater in the electrode is 0.04 cm$^3$/g or less, and more preferably 0.02 cm$^3$/g or less, water content is difficult to reach the conductive base substance, whereby the reaction of the formula (A), and thus the creation of silver ions are prevented, making no short-circuit, so that the conversion efficinecy is not degraded.

Fig. 7 shows the relation between the cavity volume and the leakage current increment rate per hour, which indicated that the leakage current increament rate per hour is particularly small or excellent when the cavity volume is 0.04 cm$^3$/g or less.

Fig. 8 shows the leakage current after ten hours, with the cavity volume being 0.02 cm$^3$/g, when a forward bias is applied under the conditions of high temperature and high humidity, and the concentration (density) of chlorine is changed, and Fig. 9 shows a minuter result thereof.

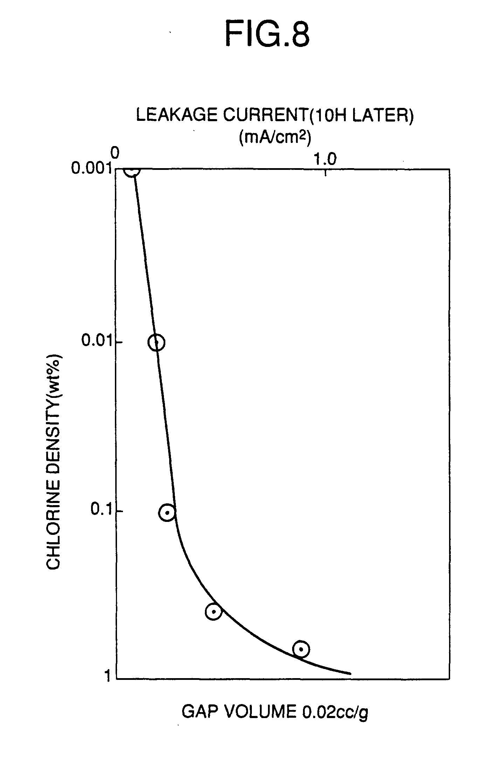

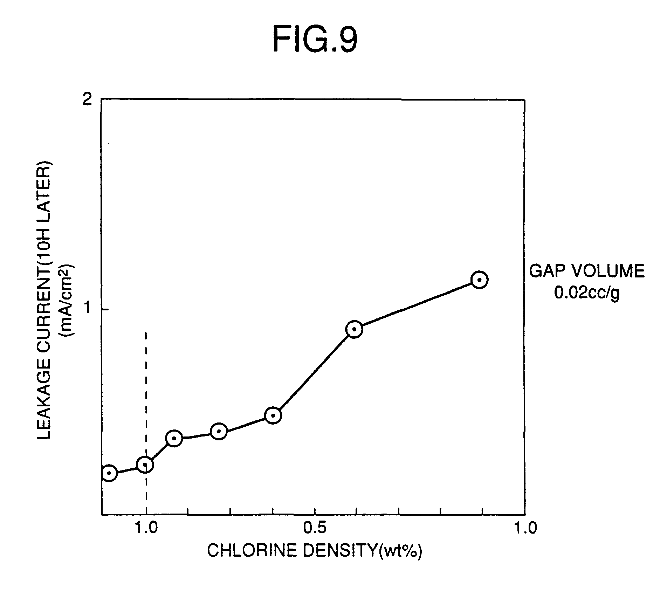

From Figs. 8 and 9, it is indicated that the smaller the concentration of chlorine contained as impurities in the electrode, the less the leakage current after ten hours, and particularly in a range of 0.10 wt% or less, the leakage current is quite smaller and particularly excellent.

According to the present invention, it is possible to provide a solar cell having a photoelectric conversion semiconductor layer and an electrode made of a material containing a solventless conductive base substance and a resin electrically connected to the photoelectric conversion semiconductor layer, in which the short-circuit between solar cell electrodes due to water content permeation can be prevented, and the environment proof is excellent, owing to the fact:

that the volume of cavities having a diameter of 0.1 µm or greater among cavities existing in the electrode is 0.04 cm$^3$/ g or less, or according to an preferred embodiment,

that the volume of cavities having a diameter of 2 nm or greater among cavities existing in the electrode is 0.04 cm$^3$/g or less, or

that the ratio of weight of the solventless conductive base substance in the grid electrode is 70% or greater, or

that the resin is urethan type, epoxy type or polyimide type, or

that the concentration of chlorine contained in the electrode as impurities is 0.1 wt% or less.

Since a mixture of resin and conductive base substance is used for the grid, the grid is attached at a low temperature, so that the solar cell can be fabricated cheaply.

Since the grid having a resin contained is bendable and durable to mechanical impact, it is possible to provide a flexible and durable solar cell.

BRIEF DESCRIPTION OF THE DRAWINGS

Fig. 1 is a solar cell.
Fig. 2 is a conventional solar cell.
Fig. 3 is an explanation view showing the principle of the degradation in the conventional solar cell.

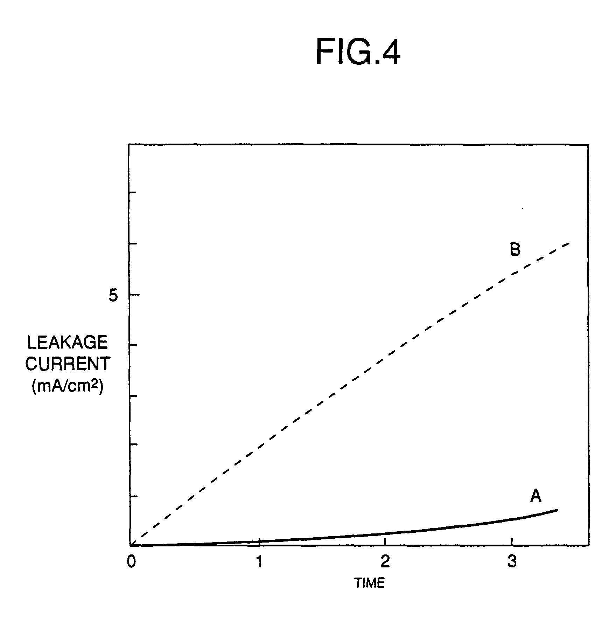

Fig. 4 shows a result of Reference Example 1.

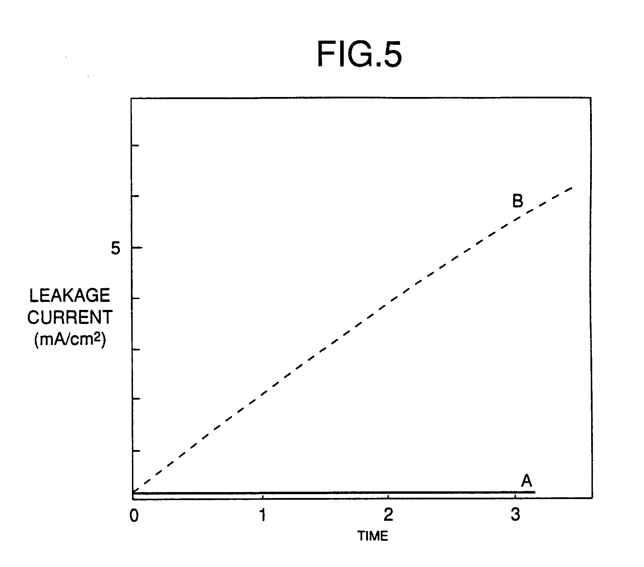

Fig. 5 shows a result of Example 2.
Fig. 6 is a view showing the improvement in the cavity volume with decreasing weight of solvent.

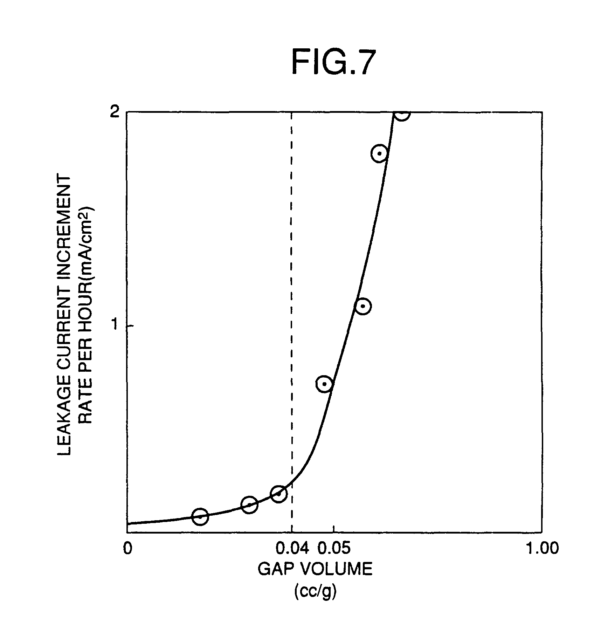

Fig. 7 is a view showing the decreasing leakage current increment rate per hour with the improved cavity volume.
Fig. 8 is a view showing the improvement in the leakage current with decreasing content of chlorine concentration.
Fig. 9 is a view showing the improvement in the leakage current with decreasing content of chlorine concentration.

DETAILED DESCRIPTION OF THE PREFERRED EMBODIMENTS

The preferred examples of the present invention will be described in detail.

[Reference Example 1]

The Reference Example is useful for understanding the present invention, but is outside the scope of the claims.
A plurality of photoelectric conversion layers composed of amorphous silicon were deposited on a stainless substratum having a thickness of 0.203 mm (8MIL) and an area of 16 cm$^2$ by plasma CVD, and a transparent conductive layer composed of an indium oxide was adhered thereto by sputtering.
Then, a conductive paste composed of an urethan type resin and silver particulates (conductive base substance 70 wt%, solvent 18 wt%, resin 12 wt%) was screen printed, and cured at a temperature of 130°C for one hour to make up a solar cell of the present invention. Total volume of cavities having a diameter of 2nm or greater in the grid electrode measured by mercury porosimetry was 0.036 cm$^3$/g, while the volume of cavities having a diameter of 1 μm or greater was 0.018 cm$^3$/g.
A forward bias of 1.2V was applied to this solar cell under the conditions at a high temperature of 85°C and a high humidity of 85%RH to appropriately measure the leakage current flowing within the solar cell. The forward bias was applied to simulate the operation state. The leakage current increment rate was 0.2 mA/cm$^2$ or less per hour, and it could be found that the elution of silver was greatly decreased. This behavior is graphically shown in Fig. 4. The longitudinal axis of Fig. 4 indicates the leakage current value per unit area, and the transversal axis indicates the time. The leakage current increment in this example is indicated by the solid line A. The dotted line indicates the leakage current increment of Comparative Example 1 as will be described later.

[Comparative Example 1]

As a comparative example, the same test as above was performed using a conductive paste composed of a polyester type resin and silver particulates (conductive base substance 70wt%, solvent 25wt%, resin 5 wt%). Total volume of cavities having a diameter of 2 nm or greater measured in the same way as example 1 was 0.065 cm$^3$/g, while the volume of cavities having a diameter of: 0.1 μm or greater was 0.046 cm$^3$/g. The leakage current increment rate reached 2.0 mA/cm$^2$ per hour.

[Comparative Example 2]

The same test as in Reference Example 1 was performed using a conductive paste composed of a vinyl type resin and silver particulates (conductive base substance 70 wt%, solvent 22 wt%, resin 8 wt%). Total volume of cavities having a diameter of 2nm or greater was 0.060 cm$^3$/g, while the volume of cavities having a diameter of 0.1 μm or greater was 0.041 cm$^3$/g. The leakage current increment rate was 1.8 mA/cm$^2$ per hour.

[Example 2]

In the same way, a solar cell was fabricated using a conductive paste composed of an epoxy type resin and silver particulates (conductive base substance 80 wt%, solventless). The curing condition was 150°C for three hours. Total volume of cavities having a diameter of 2 nm or greater was 0.018 cm$^3$/g. This is due to the fact that no solvent is contained and the epoxy type resin has a very small amount of volatile matters arising in crosslinking. Further, in the same way as in Reference Example 1, a forward bias was applied to this solar cell under the conditions at a high temperature of 85°C and a high humidity of 85%RH to measure the leakage current increment. This result is shown in Fig. 5 together with that of the Comparative Example 1. In Fig. 5, the solid line A indicates the leakage current in this example, while the dotted line B indicates the leakage current of the Comparative Example 1. In this example, the leakage current increment rate was 0.03 mA/cm$^2$ per hour, which was above 1/100 that of the comparative example. It is indicated that this value is about 1/10 that of the cavities Example 1, and a great effect can be provided by using such conductive paste having a small amount of volatile matters arising in curing.

[Example 3]

Using solventless epoxy type pastes A and B both including a conductive base substance 75% and a resin 25%, with impurities mixed in A and impurities removed in B, tandem-type amorphous solar cells A and B were fabricated in the same method as in Reference Example 1. As a result of measurement by mercury porosimetry, total volume of cavities having a diameter of 2nm or greater was 0.016 cm$^3$/g in A and 0.018 cm$^3$/g in B. On the other hand, the volume of cavities having a diameter of 1 μm or greater was almost the same value for both A and B, i.e., 0.003 cm$^3$/g. The concentration of chlorine in the electrode was 0.01 wt% in A, but it could not be detected in B. The measurement method was ion exchange chromatography. The detection limit of used equipment was 0.001 wt%.

In the same way as in previous example, a forward bias was applied to this solar cell under the conditions at a high temperature and a high humidity to measure the leakage current. The initial leakage current was 0.06 mA/cm$^2$ for both. The leakage current after ten hours was 0.2 mA/cm$^2$ in A and 0.07 mA/cm$^2$ in B. This indicates that the degradation rate will yield a difference depending on the difference in the concentration of chlorine.

The present invention can provide a solar cell excellent in the environment proof so that the short-circuit between solar cell electrodes due to water permeation can be prevented using an electrode, preferably a guid electrode in which the volume of cavities having a diameter of 0.1 μm or greater is 0.04 cm$^3$/g or less.

Further, the grid can be attached at a low temperature because of the use of a mixture of a resin and a solventless conductive base substance in the grid, whereby the solar cell can be fabricated cheaply.

Further, since the grid having the resin contained is bendable and durable to mechanical impact, it is possible to provide a flexible and durable solar cell.

As above described, according to the present invention, it is possible to provide a solar cell excellent in the environment proof at a lower cost, so that its industrial value is quite large.

A solar cell has a photoelectric conversion semiconductor layer and an electrode made of a material containing a solventless conductive base substance and a resin electrically connected to the photoelectric conversion semiconductor layer, wherein the volume of cavities having a diameter of 0.1 μm or greater among cavities existing in the electrode is 0.04 cm$^3$/g or less.

**Claims**

1.  A solar cell having a photoelectric conversion semiconductor layer and an electrode made from a solventless conductive material containing a conductive base substance and a resin electrically connected to said photoelectric conversion semiconductor layer;
    wherein among cavities existing in said electrode, volume of said cavities having a diameter of 0.1 μm or greater is 0.04 cm$^3$/g or less.

2.  A solar cell according to claim 1,
    wherein among cavities existing in said electrode, volume of said cavities having a diameter of 20 Å or greater is 0.04 cm$^3$/g or less.

3.  The solar cell according to claim 1 or 2, wherein said semiconductor is a non-single crystalline semiconductor.

4.  The solar cell according to claim 1 or 2, wherein chlorine is contained in said electrode in amounts of 0.1 wt.% or less.

5. The solar cell according to claim 1, wherein said volume of voids in said electrode having a diameter of 0.1 µm or greater is 0.02 cm$^3$/g or less.

6. The solar cell according to claim 1 or 2, further comprising a transparent conductive layer applied to said photoelectric conversion semiconductor.

7. The solar cell according to claim 1 or 2, wherein said photoelectric conversion semiconductor layer is composed of amorphous silicon having at least one pin junction.

8. The solar cell according to claim 1 or 2, wherein said resin is urethane type, epoxy type or polyimide type.

9. The solar cell according to claim 1 or 2, wherein said conductive base substance is silver, silver-palladium alloy, a mixture of silver and carbon, copper, nickel, aluminum, gold or a mixture thereof.

10. The solar cell according to claim 1 or 2, wherein the ratio of weight of said conductive base substance in said electrode is 70% or greater.


**Patentansprüche**

1. Solarzelle mit einer fotoelektrischen Umwandlungshalbleiterschicht und einer Elektrode aus einem eine leitende Basissubstanz und ein Harz enthaltenden Material, die mit der fotoelektrischen Umwandlungshalbleiterschicht elektrisch verbunden ist;
    wobei unter in der Elektrode bestehenden Hohlräumen das Volumen von Hohlräumen mit einem Durchmesser von 0,1 µm oder mehr 0,04 cm$^3$/g oder weniger beträgt.

2. Solarzelle gemäß Anspruch 1,
    wobei unter Hohlräumen, die in der Elektrode bestehen, das Volumen von Hohlräumen mit einem Durchmesser 20 Å oder mehr 0,04 cm$^3$/g oder weniger beträgt.

3. Solarzelle gemäß Anspruch 1 oder 2, wobei der Halbleiter ein nicht einkristalliner Halbleiter ist.

4. Solarzelle gemäß Anspruch 1 oder 2, wobei in der Elektrode Chlor in Mengen von 0,1 Gewichtsprozent oder weniger enthalten ist.

5. Solarzelle gemäß Anspruch 1, wobei das Volumen von Hohlräumen der Elektrode mit einem Durchmesser von 0,1 µm oder mehr 0,02 cm$^3$/g oder weniger beträgt.

6. Solarzelle gemäß Anspruch 1 oder 2, die außerdem eine transparente leitende Schicht umfasst, die auf dem fotoelektrischen Umwandlungshalbleiter aufgetragen ist.

7. Solarzelle gemäß Anspruch 1 oder 2, wobei die fotoelektrische Umwandlungshalbleiterschicht aus amorphem Silizium mit wenigstens einem pin-Übergang zusammengesetzt ist.

8. Solarzelle gemäß Anspruch 1 oder 2, wobei das Harz vom Urethan-, Epoxid-, oder Polyimidtyp ist.

9. Solarzelle gemäß Anspruch 1 oder 2, wobei die leitende Basissubstanz Silber, ein Legierung aus Silber und Palladium, eine Mischung aus Silber und Kohlenstoff, Kupfer, Nickel, Aluminium, Gold, oder deren Mischung ist.

10. Solarzelle gemäß Anspruch 1 oder 2, wobei das Gewichtsverhältnis der leitenden Basissubstanz in der Gitterelektrode 70 % oder mehr beträgt.


**Revendications**

1. Cellule solaire ayant une couche semi-conductrice de conversion photoélectrique et une électrode formée d'une matière conductrice sans solvant contenant une substance conductrice de base et une résine connectée électriquement à ladite couche semi-conductrice de conversion photoélectrique;

dans laquelle, parmi des cavités présentes dans ladite électrode, le volume desdites cavités ayant un diamètre de 0,1 µm ou plus est de 0,04 cm$^3$/g ou moins.

2. Cellule solaire selon la revendication 1,
dans laquelle, parmi des cavités présentes dans ladite électrode, le volume desdites cavités ayant un diamètre de 20 Å ou plus est de 0,04 cm$^3$ ou moins.

3. Cellule solaire selon la revendication 1 ou 2, dans laquelle ledit semi-conducteur est un semi-conducteur non monocristallin.

4. Cellule solaire selon la revendication 1 ou 2, dans laquelle ladite électrode contient du chlore en quantités de 0,1% en poids ou moins.

5. Cellule solaire selon la revendication 1, dans laquelle ledit volume des espaces vides dans ladite électrode ayant un diamètre de 0,1 µm ou plus est de 0,02 cm$^3$/g ou moins.

6. Cellule solaire selon la revendication 1 ou 2, comportant en outre une couche conductrice transparente appliquée sur ledit semi-conducteur de conversion photoélectrique.

7. Cellule solaire selon la revendication 1 ou 2, dans laquelle ladite couche de semi-conducteur de conversion photoélectrique est composée de silicium amorphe ayant au moins une jonction pin.

8. Cellule solaire selon la revendication 1 ou 2, dans laquelle ladite résine est du type uréthane, du type époxy ou du type polyimide.

9. Cellule solaire selon la revendication 1 ou 2, dans laquelle ladite substance conductrice de base est de l'argent, un alliage argent-palladium, un mélange d'argent et de carbone, du cuivre, du nickel, de l'aluminium, de l'or ou un mélange de ceux-ci.

10. Cellule solaire selon la revendication 1 ou 2, dans laquelle la proportion en poids de ladite substance conductrice de base dans ladite électrode est de 70% ou plus.

# FIG.1

# FIG.2

# FIG.3

# FIG.4

# FIG.5

# FIG.6

# FIG.7

# FIG.8

# FIG.9